(19) Europäisches Patentamt
European Patent Office
Office européen des brevets

(11) EP 0 870 332 B1

(12) **EUROPEAN PATENT SPECIFICATION**

(45) Date of publication and mention of the grant of the patent:
**01.10.2008 Bulletin 2008/40**

(21) Application number: **96928636.8**

(22) Date of filing: **08.08.1996**

(51) Int Cl.:
*H01L 21/8238* (2006.01) *H01L 27/092* (2006.01)
*H01L 29/49* (2006.01)

(86) International application number:
**PCT/IB1996/000929**

(87) International publication number:
**WO 1997/008755 (06.03.1997 Gazette 1997/11)**

(54) **Method for manufacturing a MOSFET semiconductor device with reduced off-state gate oxide field**

Verfahren zur Herstellung einer MOSFET-Halbleiteranordnung mit vermindertem Gateoxidfeld im Aus-Zustand

Méthode pour fabriquer un dispositif semi-conducteur à MOSFET à champ d'oxyde de grille réduit à l'état bloqué

(84) Designated Contracting States:
**DE FR GB IE IT**

(30) Priority: **25.08.1995 US 519669**

(43) Date of publication of application:
**14.10.1998 Bulletin 1998/42**

(73) Proprietor: **Infineon Technologies AG**
**81669 München (DE)**

(72) Inventors:
- **SCHWALKE, Udo**
**D-84431 Heldenstein (DE)**
- **HANSCH, Wilfried**
**South Burlington, VT 05403 (US)**

(74) Representative: **Epping - Hermann - Fischer Patentanwaltsgesellschaft mbH**
**Ridlerstrasse 55**
**80339 München (DE)**

(56) References cited:
**EP-A- 0 452 829** **EP-A- 0 657 929**
**EP-A- 0 661 751** **US-A- 4 151 635**

- **PATENT ABSTRACTS OF JAPAN vol. 018, no. 035 (E-1494), 19 January 1994 & JP 05 267654 A (NEC CORP), 15 October 1993,**
- **PATENT ABSTRACTS OF JAPAN vol. 017, no. 356 (E-1394), 6 July 1993 & JP 05 055560 A (FUJITSU LTD), 5 March 1993,**
- **AUR S ET AL: "POLY GATE DEPLETION EFFECTS ON NMOS HOT CARRIER RELIABILITY" 7 June 1994 , SYMPOSIUM ON VLSI TECHNOLOGY. DIGEST OF TECHNICAL PAPERS, HONOLULU, JUNE 7 - 9, 1994, NR. SYMP. 14, PAGE(S) 143/144 , INSTITUTE OF ELECTRICAL AND ELECTRONICS ENGINEERS XP000498621 see the whole document**
- **PATENT ABSTRACTS OF JAPAN vol. 011, no. 400 (E-569), 26 December 1987 & JP 62 160754 A (NIPPON GAKKI SEIZO KK), 16 July 1987,**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 0 870 332 B1

## Description

### FIELD OF THE INVENTION

The present invention relates to a semiconductor device and more particularly to a method for manufacfuring a MOSFET (metal-oxide-semiconductor field-effect-transistor) semiconductor device having improved device reliability.

### BACKGROUND OF THE INVENTION

A typical CMOS circuit application can provide very low standby power. Current flows in the circuit only when a transition of state is occurring. This feature makes it extremely easy to manage the power dissipation in CMOS designs. For an n-channel MOSFET the current carriers are electrons, whereas for a p-channel MOSFET the carriers are holes. Four separate regions or terminals exist in a MOSFET: source, drain, gate, and substrate. For normal operation, the source, drain, and gate voltages measured with respect to substrate are positive for an n-channel MOSFET and negative for a p-channel MOSFET. The output is always connected to one of the power supply rails because at any given state only one MOSFET is on and the other is off. This guarantees that the logic swing will be determined by the power supply voltage only, and not by the ratio of the effective impedance of the MOSFETs, as is the case with static nMOSFET design.

In semiconductor technology, polycrystalline silicon (polysilicon) is very frequently used as a gate electrode. The popularity of polysilicon is largely due to the fact that polysilicon is a particularly suitable material in self-registering MOS processes, in which the gate electrode and source/drain areas are defined by the same masking step. In integrated circuits, polysilicon is used for circuit wiring as well as a gate electrode.

In the realization of submicron MOSFETs decreasing gate oxide thickness ($T_{OX}$), the correspondingly increasing electric field across the thin dielectric is a major concern. With gate oxide thickness of 10 nm and smaller, the supply voltage had to be reduced from 5V to 3.3V in order to reduce the electric field across the dielectric to a safe level of below 4MV/cm. However, with decreasing supply voltage, the field enhancement caused by the workfunction difference between the $n^+$ gate electrodes and $p^+$ junction regions, or the $p^+$ gate electrodes and $n^+$ junction regions, becomes increasingly important. The workfunction difference of 1.1eV remains constant with decreasing supply voltage.

The oxide field ($E_{OX}$) can be calculated by utilizing the formula shown in Equation 1 where $V_{gate}$ represents the gate voltage, $V_{fb}$ represents the flatband voltage, and $T_{OX}$ represents the oxide thickness.

$$E_{OX}=[(\pm V_{gate})+(\pm V_{fb})]/T_{OX}$$

Equation 1.

The flatband voltage ($V_{fb}$) can be calculated by utilizing the formula shown in Equation 2 where $\Phi_{ms}$ represents the workfunction difference, $Q_{ox}$ represents the oxide charge and $C_{ox}$ the oxide capacitance.

$$V_{fb}=\Phi_{ms}+Q_{ox}/C_{ox}$$

Equation 2.

Depending upon the bias of the gate and source, the workfunction difference ($\Phi_{ms}$) will increase or decrease the electric field in the gate electrode junction region as evident from Equation 1. Fig. 1 illustrates the gate electrode-to-junction region area of a MOSFET 10, having an $n^+$ gate electrode 12, $n^-$ substrate 14 and $p^+$ junction region 16 with a gate oxide thickness ($T_{OX}$) 18. The oxide field 20 is affected by the workfunction difference ($\Phi_{ms}$) according to Equation 1.

Referring to Fig. 2, there is shown, the effect of the gate polarity on oxide field between source and drain of $n^+$ PMOSFETs and $p^+$ PMOSFETs which are in a conducting state, turned on. Fig. 3. shows the simulated oxide field along the channel for $n^+$ PMOS and $p^+$ PMOSFETs which are in a non-conducting state, turned off. The field enhancement of approximately 1MV/cm for $n^+$ PMOS FETs is due to the added workfunction difference. The results shown in Figs. 2 and 3 were obtained with two dimensional computer simulations utilizing MINIMOS. In the non-conducting off state the oxide field is increased by the workfunction difference up to 4.6MV/cm at the drain side for the $n^+$ gate PMOSFET when a nominal oxide thickness of 10nm is assumed. When a process variation of 10% in $T_{OX}$ is accounted for, a maximum oxide field of 5MV/cm will result. This enhanced oxide field will increase the risk of device failures such as oxide breakdowns and device instabilities.

MOSFETs having equal gate and junction dopant type, i.e. $p^+$ gate PMOSFET and $n^+$ gate NMOSFET, have been proposed in order to avoid the high oxide fields which were described above. Referring to Figs. 2 and 3, it can be seen that the oxide field of the $p^+$ gate PMOSFET remains below 3.6MV/cm. However, the actual implementation of such a symmetrical device design in CMOS technology complicates the process substantially. This is because a dual workfunction gate technology is required. Information on the feasibility of fabricating dual gate CMOS devices can be obtained by referring to an article entitled "Doping of n+ and p+ Polysilicon in a Dual-Gate CMOS Process", by C. Y. Wong et al. published by IEEE in IEDM Tech. Dig. 238 (1988). A polysilicon depletion occurs at reverse biases, which causes device current degradation. This effect becomes more severe as the gate oxide thickness ($T_{OX}$) becomes smaller. Reference is made to an article entitled "Effects of Depleted Poly-Si Gate on MOSFET Performance", by M. Iwase et al. published in Ext. Abstract SSDM 271 (1990) for information on dual gate symmetric CMOS structures for submicron integration and degradation of performance by the depleted gate on the device.

Therefore, reducing the workfunction related high oxide fields for single workfunction gate technologies, such as for $n^+$ gate electrode only and $p^+$ gate electrode only, for CMOS is highly desirable. One solution is through the controlled formation of gate birds beaks which have the tendency to increase the oxide thickness at the gate edges. This solution, however leads to a transconductance degradation which results in a loss of performance.

Document EP-A-0 657 929 discloses a submicron CMOS circuit comprising NMOS and PMOSFETs. Both types of transistors have an n-doped gate electrode. The gate electrode of the PMOSFET is counter-doped with boron. The counter-doping is carried out so that the gate electrode of the PMOSFET remains n-type. The work function of the gate electrode is lowered to -0.275 eV.

In Patent Abstracts of Japan, volume 17, no. 356 (E-1394), July 6, 1993 (JP-A-5-055560) a high breakdown strength MOSFET is disclosed having a gate electrode consisting of two-layered polysilicon. The polysilicon near the gate insulating film is doped with impurities at a low concentration to form a depletion layer when a high voltage is impressed between the substrate or the source region and the drain region. The other polysilicon layer is doped with impurities at a high concentration.

In Patent Abstracts of Japan, volume 18, no. 35 (E-1494), January 19, 1994 (JP-A-5-267654) a MOSFET is shown having a gate electrode doping concentration so that a depletion layer is formed. The effective thickness of the gate oxide at the time of cut-off differs from the thickness at the time of conduction to obtain a high threshold voltage at the time of cut-off.

Document EP-A-0 661 751 shows transistors with a gate electrode having such doping concentration that the portion adjacent to the gate oxide is depleted during use.

It is an object of the present invention to reduce the oxide field over the junction area for the off-state of a MOSFET semiconductor device with different gate electrode and junction region dopant type.

## SUMMARY OF THE INVENTION

According to the present invention, a method for manufacturing a MOSFET semiconductor device having a first and a second MOSFET is provided according to the features of claim 1.

Embodiments relate to a MOSFET device which utilizes the gate depletion effect to reduce the oxide field over the junction area. Since the gate depletion effect is present in the non-conducting off state for $n^+$ gate PMOSFETs and $p^+$ gate NMOSFETs, performance degradation is overcome. The level of doping of the gate is critical. In order to prevent gate depletion in the conducting, on state, the NMOS FET must use a highly doped $n^+$ gate electrode. The PMOS FET $n^+$ gate electrode must be non-degenerately doped in order to utilize the advantage of the gate depletion in the non-conducting, off state. This is accomplished by implanting different doses of the same dopant type into the different gates. The MOSFET semiconductor device can be implemented equally well for $n^+$ gate PMOSFETs as well as for $p^+$ gate NMOSFETs.

## BRIEF DESCRIPTION OF THE FIGURES

The above objects and further features and advantages of the invention are described in detail below in conjunction with the drawing, of which:

FIG. 1 shows the gate-to-junction area of a MOSFET ;
FIG. 2 shows the effect of gate polarity on the oxide field;
FIG. 3 shows oxide field for $n^+$ and $p^+$ PMOS FETs;
FIG. 4 shows a basic principle for understanding the present invention;
FIG. 5 shows a band diagram for the present invention;
FIG. 6 shows the gate stacks for an embodiment of the present invention;
FIG. 7 shows the cap layer protection during p+ implantation for an embodiment of the present invention;
FIG. 8 shows the cap layer protection during n+ implantation for an embodiment of the present invention.

## DETAILED DESCRIPTION OF THE INVENTION

While the present invention is described in the context of a conventional $n^+$ doped gate PMOS FET, it is equally well suited for a $p^+$ gate NMOS FET. The present invention can be utilized with both buried as well as surface channel devices. Although the present invention is especially well suited for use with "single workfunction" CMOS gate technologies can also be utilized with "dual workfunction" CMOS gate technologies.

The present invention utilizes the gate depletion effect to reduce the oxide field over the junction area. Since the gate depletion effect is present only in the non-conducting off state for $n^+$ gate PMOSFETs and $p^+$ gate NMOSFETs, the performance degradation is overcome.

Fig. 4 illustrates a basic principle. Shown is the gate electrode-to-junction region area of a MOSFET 30, having an $n^+$ gate electrode 32, $n^-$ substrate 34, $p^+$ junction region 36 and a depleted region 38 with a gate oxide thickness ($T_{OX}$). For a non-degenerately doped poly-Si gate electrode a depleted region 38 with a thickness $W_{poly}$ is formed over the $p^+$ junction region in the gate electrode when the MOSFET 30 is in the non-conducting, off state. The potential drop in the depleted region 38 reduces the oxide field.

Referring to Figs. 4 and 5, it can be seen that the potential drop across the gate depletion width will lower the field across the oxide. Simulation shows that for an active carrier concentration in the gate electrode of $10^{19}/cm^3$ the oxide field in the $p^+$ junction region is reduced by 0.6MV/cm.

When the PMOSFET is in the conducting, on state, the gate electrode is driven into accumulation. Therefore, when the FET is in the conducting, on state, no gate depletion effect occurs and there is no corresponding performance degradation. Furthermore, the workfunction difference ($\Phi_{ms}$) is beneficial, as it has an opposite sign which reduces the oxide field in comparison to the $p^+$ gate PMOSFET shown in Fig. 2.

In the embodiment of the present invention in a CMOS FET semiconductor device, the level of doping of the gate electrode is critical, which will now be explained. In order to prevent gate depletion in the conducting, on state, the NMOS FET must use a highly doped $n^+$ gate electrode. The PMOS FET $n^+$ gate electrode must be non-degenerately doped in order to utilize the advantage of the gate depletion in the non-conducting, off state. This is accomplished by implanting different doses of the same dopant type into the different gate electrodes. This will result in the necessity of an extra mask.

In order to avoid an extra mask, the CMOS fabrication process is modified. After n-wells, p-wells, field oxide and gate oxide is grown, gate polysilicon and a cap oxide layer is deposited. The polysilicon is non-degenerately n-doped, e.g. IE18 $Phos/cm^3$.

Referring to Fig. 6, there is illustrated a MOSFET semiconductor device 40, having a substrate 42, with a p-well region 44 and an n-well region 46, n doped regions 48, and cap layers 50 which define the MOSFET gate electrode stacks.

Referring to Fig. 7, there is shown a first mask 60 which is suitably aligned. It can also be seen that the cap layer 50 protects the gate polysilicon against implantation from the p+ implant source 54 which defines the $p^+$ source/drain regions 52. The non-degenerately n doped polysilicon remains for the PMOS FET.

Referring to Fig. 8, there is shown a second mask 62 which is suitably aligned. For the NMOS FET, after removal of the cap layer, the n doped polysilicon is converted into degenerately doped n+ polysilicon 49 by means of the implantation from the $n^+$ implant source 58 which defines the $n^+$ source/drain regions 67.

Sources for implanting p+ and n+ impurities include boron and arsenic ion implantation. Other sources for implanting impurities are well known to those ordinarily skilled in the art. In order to provide good electrical contact to the high resistive gate and to minimize gate delay, the gate polysilicon is electrically shunted by enhancing the conductivity, therefore lowering gate electrode resistivity, of the gate surface. This can be done by means of e.g. gate electrode silicidation (i.e. Ti-SALICIDE process) or selective metal, deposition (e.g. CVD-tungsten).

The fabrication process is then completed. The remaining steps involve inter metal-dielectric, contact holes, metalization and other steps that are well known to those ordinarily skilled in the art.

## Claims

1. A method for manufacturing a MOSFET semiconductor device (40) with a first and a second MOSFET , comprising:

   - providing a semiconductor body (42);
   - forming a comparatively thin dielectric layer on said semiconductor body (42);
   - depositing gate polysilicon (48) upon said dielectric layer and forming gate electrodes of a first and a second MOSFET ;
   - non-degenerately doping said gate polysilicon (48) of said MOSFETs with a second type of dopant having a second doping polarity ($n^+$);
   - depositing a cap layer (50) upon said doped gate polysilicon (48);
   - positioning a first mask (60) onto the area of said second MOSFET ;
   - implanting a first type of dopant having a first doping polarity ($p^+$) to form source and drain regions of said first MOSFET ;
   - removing the first mask (60) after implanting the first type of dopant ($p^+$);
   - removing said cap layer (50) from said doped gate polysilicon (48) of said second MOSFET ;
   - positioning a second mask (62) onto the area of said first MOSFET ;
   - implanting a second type of dopant ($n^+$) to form source and drain regions of said second MOSFET and to degenerately dope said gate polysilicon of said second MOSFET ;
   - removing said second mask (62) after implanting said second type of dopant ($n^+$).

2. The method as recited in claim 1, further comprising the steps of:

   - activating dopants; and,
   - lowering gate electrode resistivity.

3. The method as recited in claim 2, wherein lowering gate electrode resistivity comprises the step of:

   - performing gate electrode silicidation.

4. The method as recited in any of claims 1 to 3, wherein the first type of dopant is a $p^+$ implant.

5. The method as recited in any of claims 1 to 4, wherein the second type of dopant is an $n^+$ implant.

6. The method as recited in any of claims 1 to 5, wherein the cap layer is an oxide layer.

7. The method as recited in claim 4, wherein the $p^+$ implant is provided by ion implantation.

8. The method as recited in claim 5, wherein the $n^+$ implant is provided by ion implantation.

9. The method as recited in claim 7, wherein the ion implantation is boron ion implantation.

10. The method as recited in claim 8, wherein the ion implantation is arsenic ion implantation.

**Patentansprüche**

1. Verfahren zur Herstellung eines MOSFET Halbleiterelements (40) mit einem ersten und einem zweiten MOSFET, umfassend:

    - Bereitstellen eines Halbleiterkörpers (42);
    - Ausbilden einer vergleichsweise dünnen dielektrischen Schicht auf dem Halbleiterkörper (42);
    - Abscheiden von Gate-Polysilizium (48) auf der dielektrischen Schicht und Ausbilden von Gate-Elektroden eines ersten und eines zweiten MOSFET;
    - nicht entartetes Dotieren des Gate-Polysiliziums (48) der MOSFETs mit einer zweiten Art von Dotierstoff mit einer zweiten Dotierungspolarität ($n^+$);
    - Abscheiden einer Abschlussschicht (50) auf dem dotierten Gate-Polysilizium (48);
    - Positionieren einer ersten Maske (60) auf dem Bereich des zweiten MOSFET;
    - Implantieren einer ersten Art von Dotierstoff mit einer ersten Dotierungspolarität ($p^+$) zum Ausbilden von Source- und Draingebieten des ersten MOSFET;
    - Entfernen der ersten Maske (60) nach dem Implantieren der ersten Art von Dotierstoff ($p^+$);
    - Entfernen der Abschlussschicht (50) von dem dotierten Gate-Polysilizium (48) des zweiten MOSFET;
    - Positionieren einer zweiten Maske (62) auf dem Gebiet des ersten MOSFET;
    - Implantieren einer zweiten Art von Dotierstoff ($n^+$), um Source- und Draingebiete des zweiten MOSFET auszubilden und das Gate-Polysilizium des zweiten MOSFET entartet zu dotieren;
    - Entfernen der zweiten Maske (62) nach dem Implantieren der zweiten Art von Dotierstoff ($n^+$).

2. Verfahren nach Anspruch 1, des Weiteren umfassend die Schritte:

    - Aktivieren der Dotierstoffe und
    - Verringern des Widerstands der Gate-Elektroden.

3. Verfahren nach Anspruch 2, wobei das Verringern des Widerstands der Gate-Elektroden den Schritt umfasst:

    - Ausführen einer Silizidierung der Gate-Elektroden.

4. Verfahren nach einem der Ansprüche 1 bis 3, wobei die erste Art von Dotierstoff eine $p^+$ Implantierung ist.

5. Verfahren nach einem der Ansprüche 1 bis 4, wobei die zweite Art von Dotierstoff eine $n^+$ Implantierung ist.

6. Verfahren nach einem der Ansprüche 1 bis 5, wobei die Abschlussschicht eine Oxidschicht ist.

7. Verfahren nach Anspruch 4, wobei die $p^+$ Implantierung durch Ionenimplantation bereitgestellt wird.

8. Verfahren nach Anspruch 5, wobei die $n^+$ Implantierung durch Ionenimplantation bereitgestellt wird.

9. Verfahren nach Anspruch 7, wobei die Ionenimplantation eine Borionenimplantation ist.

10. Verfahren nach Anspruch 8, wobei die Ionenimplantation eine Arsenionenimplantation ist.

**Revendications**

1. Procédé de production d'un dispositif (40) MOSFET à semi-conducteur ayant un premier et un deuxième MOSFET, dans lequel :

    - on se procure un corps (42) semi-conducteur ;
    - on forme une couche diélectrique comparativement mince sur le corps (42) semi-conducteur ;
    - on dépose du polysilicium (48) de grille sur la couche diélectrique et on forme des électrodes de grille d'un premier et d'un deuxième MOSFET ;
    - on dope non dégénérativement le polysilicium (48) de grille des MOSFETs par un deuxième type d'agent de dopage ayant une deuxième polarité ($n^+$) de dopage ;

- on dépose une couche (50) de protection sur le polysilicium (48) de grille dopé ;
- on met un premier masque (60) en position sur la zone du deuxième MOSFET ;
- on implante un premier type d'agent de dopage ayant une première polarité ($p^+$) de dopage pour former des régions de source et de drain du premier MOSFET ;
- on élimine le premier masque (60) après implantation du premier type d'agent de dopage ($p^+$) ;
- on élimine la couche (50) de protection du polysilicium (48) de grille dopé du deuxième MOSFET ;
- on met un deuxième masque (62) en position sur la zone du premier MOSFET ;
- on implante un deuxième type d'agent de dopage ($n^+$) pour former des régions de source et de drain du deuxième MOSFET et pour doper de manière dégénérative le polysilicium de grille du deuxième MOSFET ;
- on élimine le deuxième masque (62) après implantation du deuxième type d'agent de dopage ($n^+$).

**2.** Procédé suivant la revendication 1, dans lequel, en outre :

- on active des agents de dopage ; et
- on abaisse la résistivité de l'électrode de grille.

**3.** Procédé suivant la revendication 2, dans lequel abaisser la résistivité de l'électrode de grille comprend le stade dans lequel :

- on effectue une siliciuration de l'électrode de grille.

**4.** Procédé suivant l'une quelconque des revendications 1 à 3, dans lequel le premier type d'agent de dopage est un implant $p^+$.

**5.** Procédé suivant l'une quelconque des revendications 1 à 4, dans lequel le deuxième type d'agent de dopage est un implant $n^+$.

**6.** Procédé suivant l'une quelconque des revendications 1 à 5, dans lequel la couche de protection est une couche d'oxyde.

**7.** Procédé suivant la revendication 4, dans lequel l'implant $p^+$ est obtenu par implantation d'ions.

**8.** Procédé suivant la revendication 5, dans lequel l'implant $n^+$ est obtenu par implantation d'ions.

**9.** Procédé suivant la revendication 7, dans lequel l'implantation d'ion est une implantation d'ions bore.

**10.** Procédé suivant la revendication 8, dans lequel l'implantation d'ion est une implantation d'ions arsénie.

FIG. 1

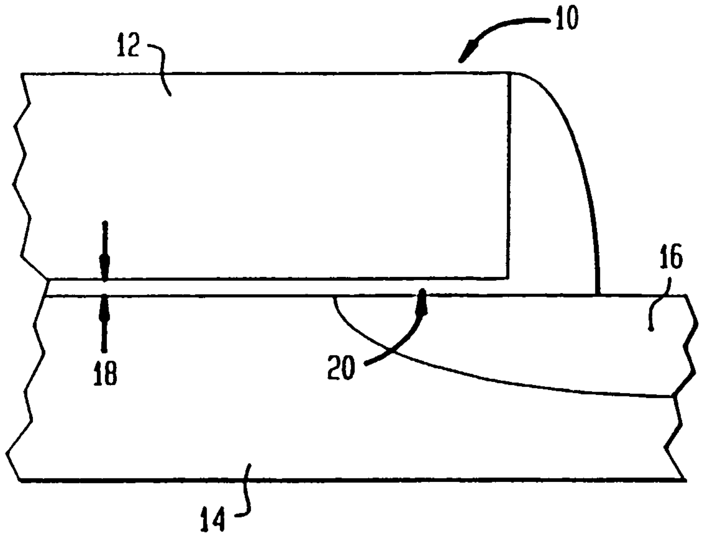
10
12
16
18
20
14

FIG. 2

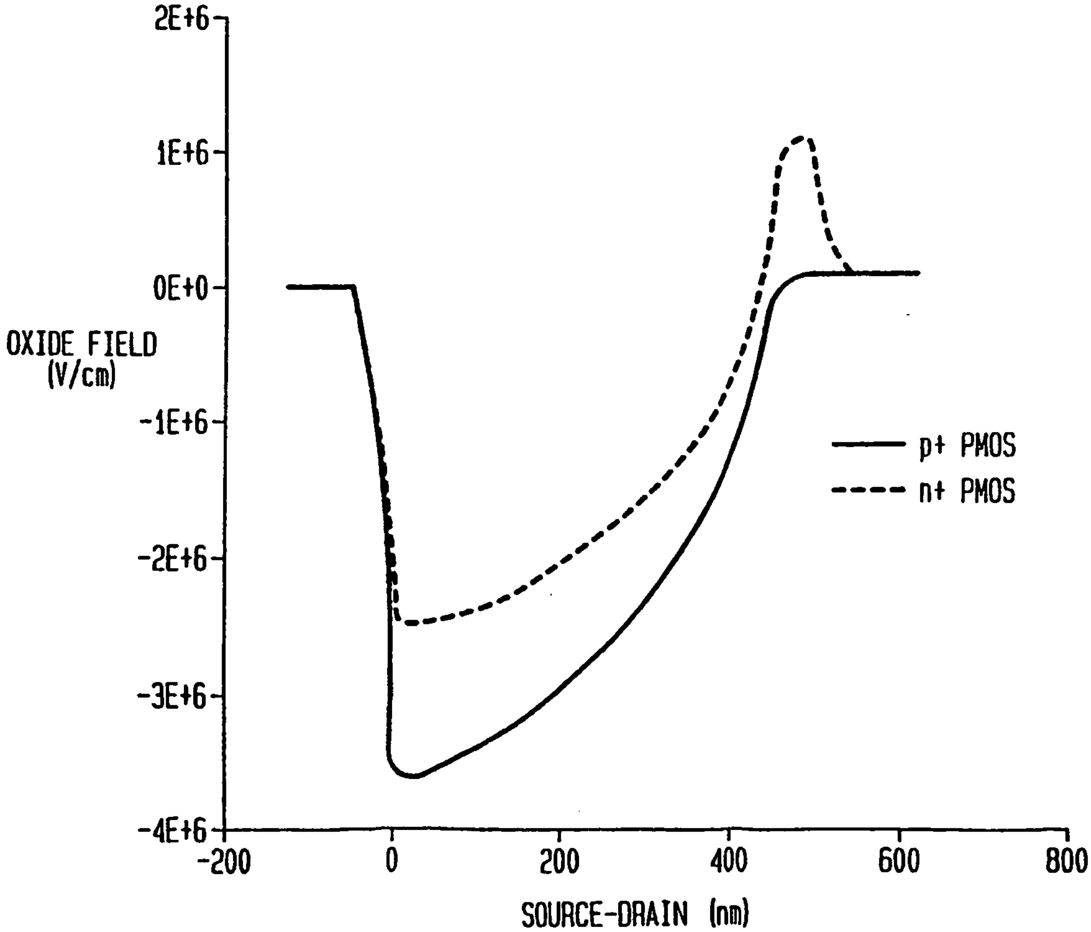
2E+6
1E+6
0E+0
OXIDE FIELD (V/cm)
-1E+6
-2E+6
-3E+6
-4E+6
-200
0
200
400
600
800
SOURCE-DRAIN (nm)
p+ PMOS
n+ PMOS

FIG. 3

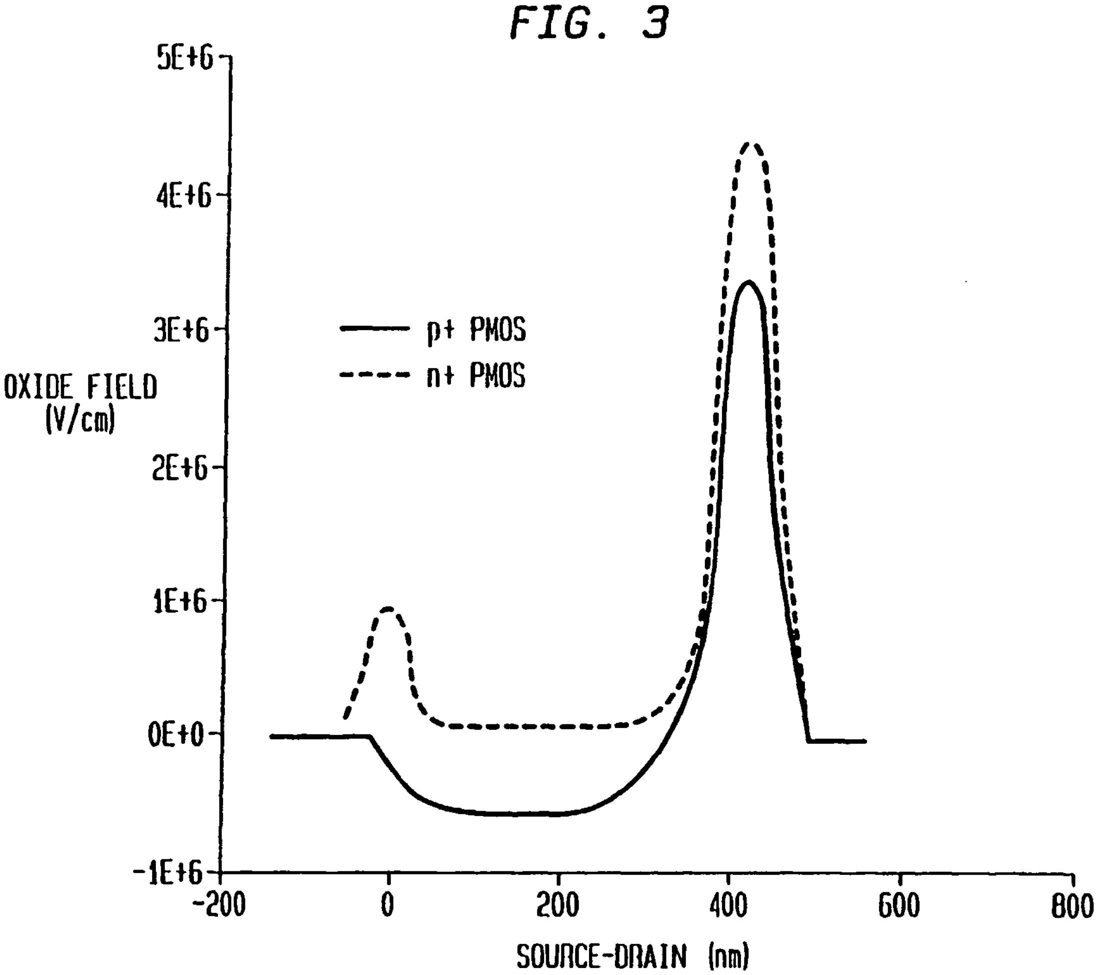
5E+6
4E+6
3E+6
2E+6
1E+6
0E+0
-1E+6
OXIDE FIELD (V/cm)
p+ PMOS
n+ PMOS
-200
0
200
400
600
800
SOURCE-DRAIN (nm)

FIG. 4

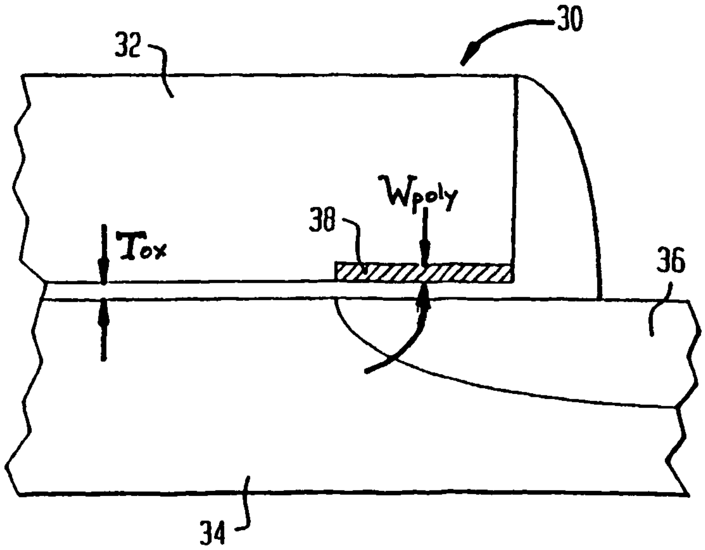
30
32
38
Wpoly
Tox
36
34

FIG. 5

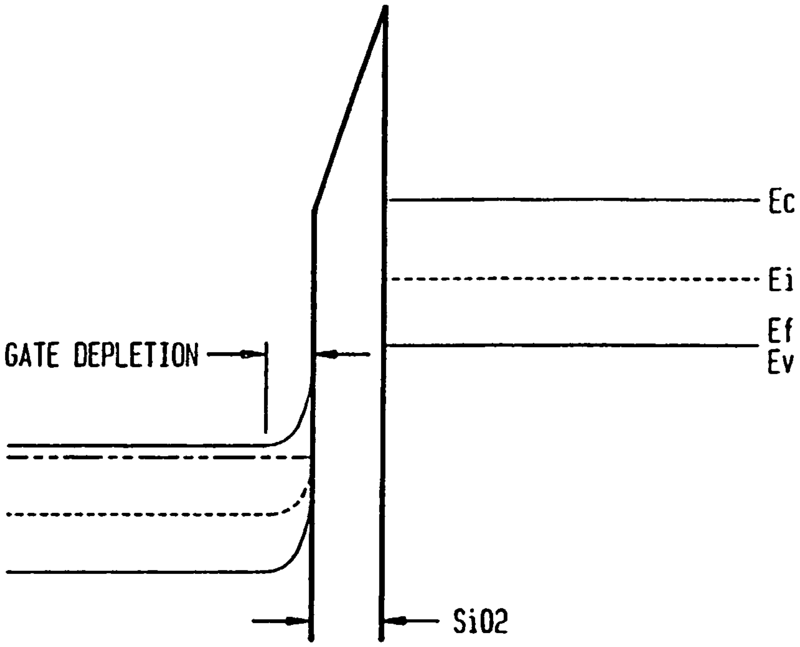


FIG. 6

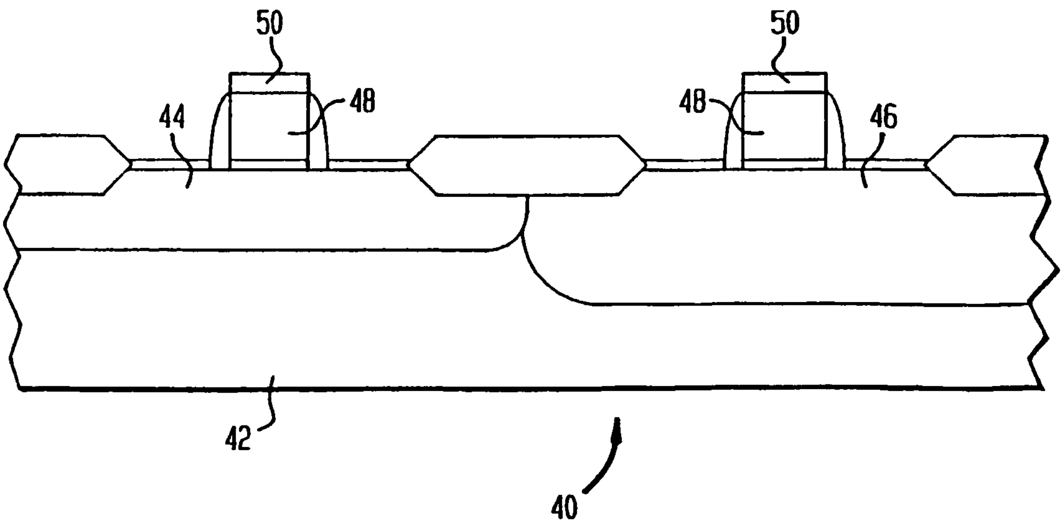

FIG. 7

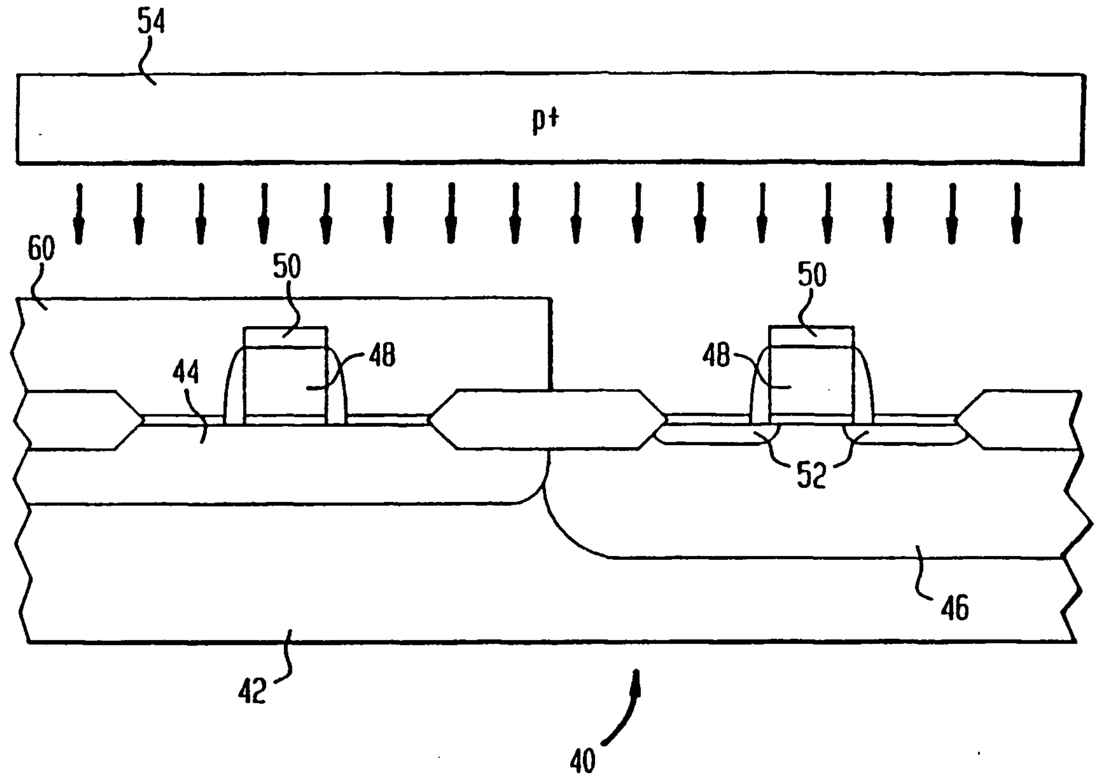


FIG. 8

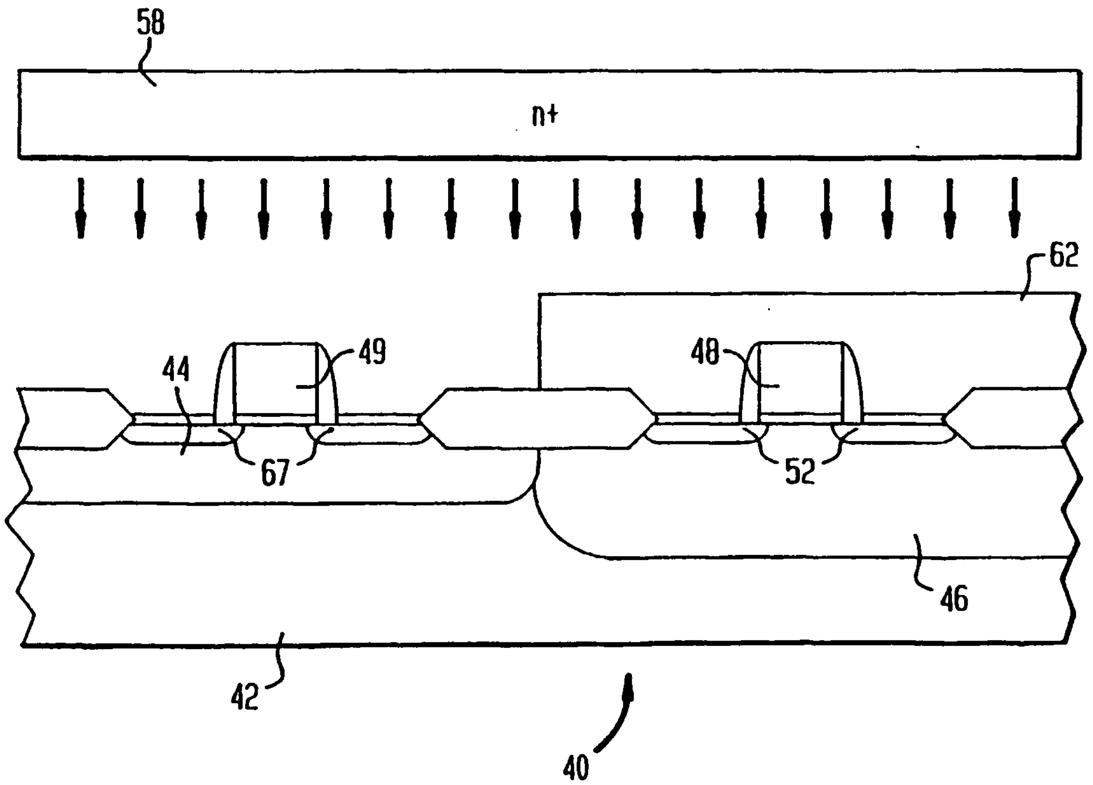

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 0657929 A
- JP 5055560 A
- JP 5267654 A
- EP 0661751 A


### Non-patent literature cited in the description


- **C. Y. WONG et al.** Doping of n+ and p+ Polysilicon in a Dual-Gate CMOS Process. *IEEE in IEDM Tech. Dig.,* 1988, 238
- **M. IWASE et al.** Effects of Depleted Poly-Si Gate on MOSFET Performance. *Ext. Abstract SSDM,* 1990, 271
- *PATENT ABSTRACTS OF JAPAN,* 06 July 1993, vol. 17, 356 (E-1394
- *PATENT ABSTRACTS OF JAPAN,* 19 January 1994, vol. 18, 35 (E-1494